**Europäisches Patentamt**

(19) **European Patent Office**

**Office européen des brevets**

(11) Veröffentlichungsnummer: **0 013 697**
**B1**

(12) **EUROPÄISCHE PATENTSCHRIFT**

(45) Veröffentlichungstag der Patentschrift:
**28.07.82**

(51) Int. Cl.³: **G 11 C 19/28**, G 11 C 11/24

(21) Anmeldenummer: **79104227.8**

(22) Anmeldetag: **31.10.79**

(54) **Auffrischung benötigendes seitenorganisiertes Speichersystem.**

(30) Priorität: **26.12.78 US 973294**

(43) Veröffentlichungstag der Anmeldung:
**06.08.80 Patentblatt 80/16**

(45) Bekanntmachung des Hinweises auf die Patenterteilung:
**28.07.82 Patentblatt 82/30**

(84) Benannte Vertragsstaaten:
**DE FR GB**

(56) Entgegenhaltungen:
**US-A-3 737 879**
**US-A-3 766 534**
**US-A-3 800 295**
**US-A-3 810 129**
**US-A-3 811 117**
**US-A-3 846 765**
**US-A-3 859 640**
**US-A-3 997 882**
**US-A-4 024 512**
**US-A-4 084 154**
**US-A-4 112 513**
**US-A-4 152 780**
**US-A-4 165 541**
**US-A-4 172 282**

(73) Patentinhaber: **International Business Machines Corporation, Armonk, N.Y. 10504 (US)**

(72) Erfinder: **Aichelmann Jr., Frederick John, R.D. No. 7 Taconic Drive, Hopewell Junction, NY (US)**

(74) Vertreter: **Böhmer, Hans Erich, Dipl.-Ing., Schönaicher Strasse 220, D-7030 Böblingen (DE)**

(56) Entgegenhaltungen:
**INTEL MEMORY DISIGN HANDBOOK, 1975 Seiten 9-1 - 9-30, Santa Clara, U.S.A. PAPENBERG: «Design and Applications of Intel's 2416 16K Charge Coupled Device» IBM TECHNICAL DISCLOSURE BULLETIN, Band 16, Nr. 3, August 1973, Seiten 934-936, Armonk, U.S.A. GERARDIN et al.: «Transparent Refreshing for Semi-Conductor Dynamic RAM»**

## Auffrischung benötigendes seitenorganisiertes Speichersystem

Die Erfindung betrifft ein für Datenverarbeitungsanlagen geeignetes Speichersystem, das in vorbestimmten Zeitabschnitten eine Wiederauffrischung des Speicherinhalts erfordert, damit die Daten in dem Speichersystem gehalten werden können. Nach einem Ausführungsbeispiel betrifft die Erfindung dabei die Verwendung von CCD-Speichern in einem zeilenadressierten Speicher mit wahlfreiem Zugriff (LARAM) in einem Seitenspeicher.

Beschreibung des Standes der Technik

Seit kurzem sind ladungsgekoppelte Vorrichtungen für Speicher in Datenverarbeitungsanlagen verfügbar. Die Grundschaltung für einen ladungsgekoppelten Speicher ist ein Schieberegister, das aus einer Zeile von kapazitiven Speicherelementen aufgebaugt ist, die gespeicherte Ladungen, gesteuert durch ein Taktsignal, von einer Speicherposition nach der nächsten weiterleiten können. Da die einzelnen Speicherelemente im wesentlichen kapazitiver Art sind und damit Leckströmen ausgesetzt sind, müssen die Daten in jedem Schieberegister erneut in Umlauf gebracht oder innerhalb eines vorbestimmten Zeitintervalls aufgefrischt werden, da andernfalls die gespeicherten Daten verlorengehen.

Seit kurzer Zeit sind auf einem einzigen Halbleiterplättchen angeordnete, mehrfache CCD-Schieberegister verfügbar. Dazu wurden verschiedene Organisationsformen vorgeschlagen, doch erscheint derzeit ein zeilenadressierbarer Speicher mit wahlfreiem Zugriff (LARAM) am geeignetsten. Eine derartige Schaltung ist beispielsweise in der US-Patentschrift 4 024 512 vom 17. Mai 1977 beschrieben und besteht aus einer Anzahl von zwischen einer gemeinsamen Ausgangssammelleitung und einer gemeinsamen Eingangssammelleitung parallel geschalteten Schieberegistern. Dabei sind jedoch gesonderte Ansteuer- oder Auswahlleitungen zur Auswahl oder Ansteuerung eines vorbestimmten Schieberegisters innerhalb einer Speicherschaltung vorgesehen. Zum Einlesen von Daten in ein ausgewähltes Schieberegister wird die entsprechende Adress- oder Auswahlleitung aufgetastet, und die Daten werden über einen Eingabepuffer, gesteuert durch ein Taktsignal, und durch interne Steuerlogik auf die Eingangssammelleitung gegeben. Zum Auslesen von Daten wird die entsprechende Adress- oder Auswahlleitung wiederum betätigt und ein Taktsignal angelegt. Die Daten werden dann aus dem ausgewählten Schieberegister über einen Ladungsabfühlverstärker auf die Ausgangssammelleitung und über einen Ausgangspuffer nach der Datenausgangsleitung ausgelesen. Zum Wiederauffrischen eines bestimmten Schieberegisters wird die entsprechende Adresse oder Auswahlleitung aufgetastet, das Taktsignal angelegt und die Daten über den Ladungsabfühlverstärker auf die Ausgangssammelleitung abgegeben. Diese Daten durchlaufen dann eine Regenerationsschleife und gelangen über die Steuerlogik und den Eingabepuffer wieder auf die Eingangssammelleitung und von dort in das gleiche Schieberegister zurück. Da für jede Schleife von Schieberegistern nur ein einziger ladungsabfühlverstärker vorgesehen ist, muss jedes Schieberegister, unabhängig von allen anderen Schieberegistern und zu einem anderen Zeitintervall wieder aufgefrischt werden. Es ist ausserdem nicht möglich, Daten aus einem Schieberegister auszulesen, während ein anderes Schieberegister auf dem gleichen, mit einem LARAM-Speicher versehenen Halbleiterplättchen wieder aufgefrischt wird.

Für mittlere und grosse datenverarbeitende Anlagen wurden ladungsgekoppelte Speicherschaltungen schon in einer Reihe von verschiedenen Anordnungen vorgeschlagen, um die Lücke zwischen langsamen und preiswerten Plattenspeichern und sehr schnellen, sehr teuren Speichern mit wahlfreiem Zugriff zu schliessen. CCD-Speicher konnten jedoch bisher das tatsächlich in ihnen steckende Potential nicht voll erfüllen, weil sie wieder aufgefrischt werden müssen. Das heisst, dass ein merklicher Teil der Gesamtzeit für die Auffrischung der ladungsgekoppelten Speicher verwendet werden muss, was natürlich zur Gesamtzeit hinzu addiert werden muss, die zum Auslesen von Daten aus derartigen Speichern erforderlich ist.

Ein Speichersystem, bei dem ladungsgekoppelte Speicher mit Vorteil eingesetzt werden können, ist ein sogenannter Seitenspeicher. Ein Seitenspeicher, der die im Oberbegriff des Anspruch 1 angegebenen Merkmale der Erfindung aufweist, ist aus der FR-A-2 371 747 bekannt. In der Organisation eines solchen Speichers ist eine Anzahl von parallel betriebenen Speichereinheiten vorgesehen, die alle gemeinsam über gemeinsame Daten-, Adress- und Steuersammelleitungen mit einer Steuerschaltung verbunden sind. Jeder Speicher enthält eine Anzahl von Speichereinheiten, die jeweils einen einzelnen Datenblock oder mehrere Datenblökke speichern können. Für die gesamte Gruppe von Speichereinheiten innerhalb eines einzigen Speichers ist eine einzige Schnittstellenlogik mit einer Taktsteuerung und einer Auffrischsteuerung vorgesehen. Dabei werden Daten immer blockweise aus einer Speichereinheit ausgelesen. Dabei besteht normalerweise ein Datenblock aus 4 096 (4 K) Bytes von je 9 Bits.

Innerhalb jedes Speichers bestimmen die Schnittstellenlogik, die Taktschaltung und die Wiederauffrischsteuerung, wie die Daten auf die verschiedenen Speichereinheiten zur Speicherung verteilt werden, und steuert das Auslesen der Daten sowie die Wiederauffrischung der einzelnen Speichereinheiten unabhängig vom Einlesen oder Auslesen von Daten durch die Steuerung. Jede Speichereinheit kann dabei aus einer Anzahl von Schieberegisterelementen bestehen, die jeweils einen Teil der Daten enthalten. Ein Datenblock kann dabei an jedem Ort in einer Speichereinheit beginnen und sich über eine oder mehrere weitere Speichereinheiten fortsetzen.

Man kann also daraus die der Erfindung zugrundeliegende Aufgabe dahingehend ableiten, dass ein Seitenspeicher geschaffen werden soll, bei welchem beim Auslesen von Daten wegen der notwendigen Wiederauffrischung von Daten, die in den Schieberegistern der einzelnen Speichereinheiten enthalten und abgespeichert sind, keine Zeit verlorengeht. Diese Aufgabe lässt sich durch die im Anspruch 1 gekennzeichnete Erfindung lösen; Ausgestaltungen der Erfindung sind in den Unteransprüchen gekennzeichnet.

Die Erfindung wird nunmehr anhand von Ausführungsbeispielen in Verbindung mit den beigefügten Zeichnungen im einzelnen erläutert.

In den Zeichnungen zeigt

Fig. 1 ein verallgemeinertes Blockschaltbild eines Speichersystems für eine Datenverarbeitungsanlage, bei welchem die Erfindung mit Vorteil einsetzbar ist,

Fig. 2 ein Blockschaltbild eines Speichersystems gemäss der Erfindung,

Fig. 3 ein Blockschaltbild einer der Speichereinheiten, wie sie in dem Speichersystem von Fig. 2 verwendet werden,

Fign. 4A bis 4E Zeitdiagramme zur Erläuterung der Arbeitsweise der Erfindung und

Fig. 5 ein Blockschaltbild eines Teils der Schnittstellenlogik, der Taktschaltung und der Wiederauffrischsteuerung gemäss Fig. 2.

Beschreibung der bevorzugten Ausführungsformen

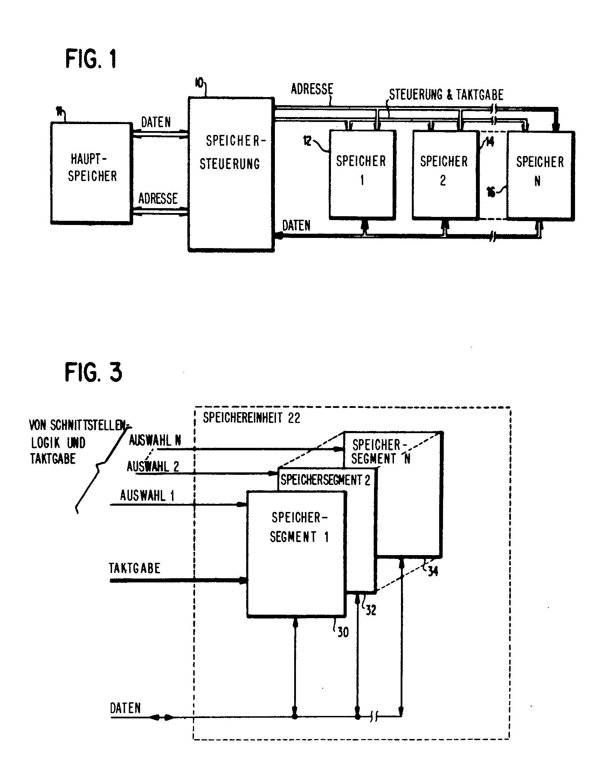

In Fig. 1 ist die gesamte Speicherorganisation einer Datenverarbeitungsanlage mit Seitenspeicherung gezeigt, bei welcher die erfindungsgemäss aufgebaute Speicheranordnung vorteilhaft einsetzbar ist. In diesem System steuert eine Steuerung 10 die Übertragung von Blöcken digitaler Daten von den einzelnen Speichern 12 bis 16 nach einem System-Hauptspeicher 11. Bei Speichersystemen mit Seitenspeicher wird ein Datenblock, der beispielsweise aus 4 096 Bytes bestehen kann, die in einer bevorzugten Anordnung von 8 × 512 Bytes geordnet sind, in einem oder mehreren der Speicher 12 bis 16 abgespeichert. Jeder Datenblock kann alleine in einem einzigen Speicher 12 bis 16 abgespeichert werden oder, was gebräuchlicher ist, kann ein Teil eines Datenblocks in einem Speicher und ein anderer Teil in einem anderen Speicher der Speicher 12 bis 16 gespeichert sein.

Wenn Daten aus den Speichern 12 bis 16 abgerufen und übertragen werden sollen, dann wird die Anfangsadresse über die Adresseammelleitung nach der Steuerung 10 und von dort an den Hauptspeicher 11 übertragen, der ein Speicher mit wahlfreiem Zugriff sein kann. Die Steuerung 10 modifiziert dann die Adresse und passt sie an die Adressierfolge an, die mit den Speichern 12 bis 16 verwendet wird und gibt dann die richtige Adresse auf die Ausgangsadresssammelleitung ab, an der alle Speicher 12 bis 16 angeschlossen sind. Die Taktgabe und die Steuersignale werden ebenfalls für die Steuerung des Auslesevorgangs erzeugt. Die aus den Speichern 12 bis 16 ausgelesenen Daten werden dann über die Steuerung 10 und die Ausgangsdatensammelleitung nach dem Hauptspeicher 11 übetragen. Der Hauptspeicher 11 ist vorzugsweise ein Speicher mit wahlfreiem Zugriff und kann bei manchen Ausführungsformen der Hauptspeicher mit wahlfreiem Zugriff für das gesamte Datenverarbeitungssystem sein. In anderen Fällen kann der Hauptspeicher 11 ein Teilspeicher sein, der als Pufferspeicher zwischen dem in Fig. 1 gezeigten System und dem Rest der Datenverarbeitungsanlage oder einem anderen Benutzer der Daten angeordnet ist. Da der Hauptspeicher keine Operationen durchzuführen hat oder die Daten weiterübertragen muss, bevor nicht der gesamte Datenblock im Hauptspeicher liegt, ist es nicht erforderlich, die Daten nacheinander vom Anfang bis zum Ende in irgendeiner festgelegten, nicht veränderbaren Reihenfolge zu übertragen.

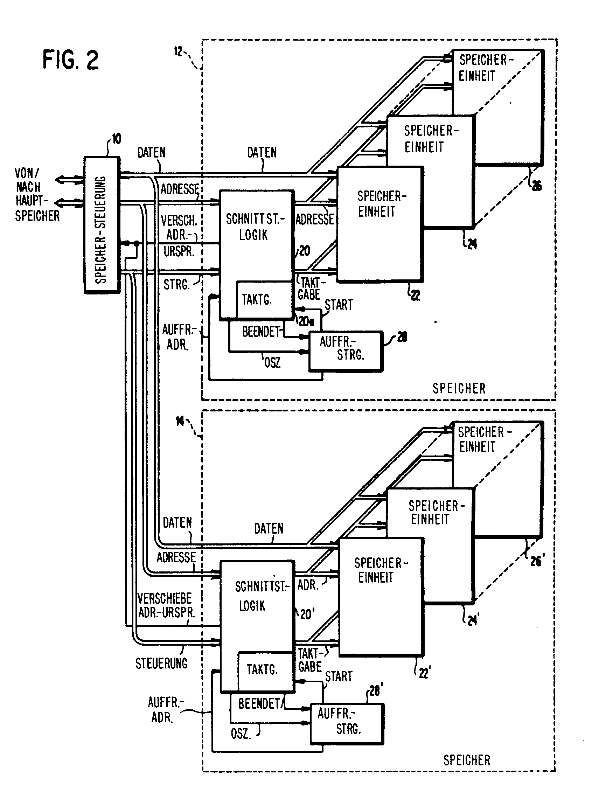

In Fig. 2 ist das in Fig. 1 dargestellte System mit mehr Einzelheiten gezeigt. Jeder Speicher 12 bis 16 enthält eine Anzahl von Speichereinheiten 22 bis 26, deren Anzahl hier an sich nicht wichtig ist, da je nach Anwendungsgebiet jede Anzahl von Speichereinheiten verwendet werden kann. Jede Speichereinheit nimmt Daten unmittelbar von der Steuerung 10 über eine Datensammelleitung auf. Die Adresssignale werden von der Steuerung 10 über die Schnittstellenlogik 20 den verschiedenen Adresseingängen der Speichereinheiten 22 bis 26 zugeführt. In gleicher Weise werden die durch die Steuerung 10 erzeugten Steuersignale den Eingängen der Schnittstellenlogik 20 zugeführt, die wiederum die Taktsignale für den Betrieb der einzelnen Speichereinheiten 22 bis 26 liefert. Innerhalb der Schnittstellenlogik 20 arbeitet die Taktschaltung 20a mit der äusseren Auffrischsteuerung 28 zusammen und liefert die erforderlichen Taktsignale zum Einspeichern und Auslesen von Daten in den Speichereinheiten 22 bis 26 und für die notwendigen Wiederauffrisch-Operationen.

In der bevorzugten Ausführungsform der Erfindung ist jede Speichereinheit 22 bis 26 ein zeilenadressierter Speicher mit wahlfreiem Zugriff (LARAM), wie er beispielsweise in der US-Patentschrift 4 024 512 beschrieben ist.

Da die Speichereinheiten 22 bis 26 unter Verwendung von CCD-Schieberegistern in Form von zeilenadressierbaren Speichern mit wahlfreiem Zugriff organisiert sind, ist in vorbestimmten Zeitintervallen eine Wiederauffrischung für jede Speichereinheit 22 bis 26 erforderlich, so dass die in jedem einzelnen Schieberegister eingespeicherten Daten erneut in Umlauf gebracht werden, damit aufgefrischt werden, wodurch der Verlust von Daten vermieden wird.

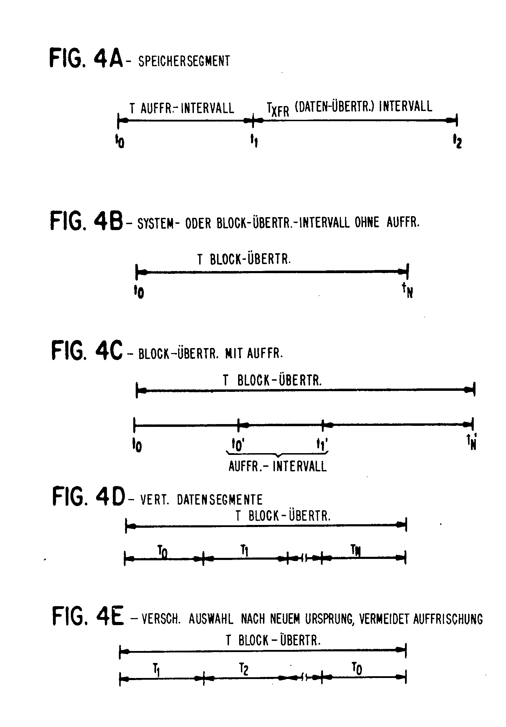

Der innere Aufbau einer Speichereinheit ist in vereinfachter Form in Fig. 3 gezeigt. Wie dargestellt, enthält jede Speichereinheit eine Anzahl von Speichersegmenten 30 bis 34, die jeweils ein Schieberegister darstellen. Während einer Wiederauffrischung werden die Auswahlleitungen 1 bis N nacheinander betätigt und die Daten werden so aus den Speichersegmenten 30 bis 34 ausgelesen, wie die entsprechende Auswahlleitung angesteuert wird. Die aus jedem Speichersegment 30 bis 34 ausgelesenen Daten werden über einen Abfühlverstärker (nicht gezeigt) und eine Rückkopplungsschleife (nicht gezeigt) den entsprechenden Dateneingängen wieder zugeführt. Die dafür benötigten Taktsignale werden von der Schnittstellenlogik 20 über die Taktleitung zugeführt, die an jedem der Speichersegmente 30 bis 34 angeschlossen ist.

Gemäss einem Merkmal der Erfindung wird unter Hinweis auf Fig. 2 die Anfangsadresse eines jeden innerhalb der Speichereinheit 12 abgespeicherten Datenblocks so eingestellt, dass sie bei einer anderen als der Anfangsadresse innerhalb eines der Speichersegmente 30 bis 34 beginnt, so dass es während einer Ausleseoperation notwendig ist, Daten aus mindestens zwei verschiedenen Speichersegmenten auszulesen. Vorzugsweise wird die Anfangsadresse eines Datenblocks so eingesetzt, dass sie etwa in der Mitte der Adressen für eines der Speichersegmente beginnt.

Während einer Auslese-Operation wird die Anfangsadresse eines oder mehrerer Datenblocks, die über die Steuerung 10 ausgelesen werden sollen, durch die Steuerung 10 an die Schnittstellenlogik 20 wieder übermittelt, die diese einlaufende Adresse in die entsprechende Adresse für die Speichereinheiten 22 bis 26 umsetzt. Falls keine Wiederauffrischung erforderlich ist, würden die Daten, beginnend mit der durch die Schnittstellenlogik 20 festgelegten Adresse und über anschliessende Speichersegmente nacheinander fortgesetzt ausgelesen werden, bis die gewünschte Datenmenge übertragen ist.

Es ist jedoch zu erwarten, dass während eines Auslesevorgangs eines oder mehrere der Speichersegmente einer Wiederauffrischung unterzogen werden muss, damit die darin gespeicherten Daten nicht verlorengehen. Wenn der Auslesevorgang vollständig der Reihenfolge nach ablaufen sollte, dann wäre es zwingend erforderlich, den Auslesevorgang anzuhalten und zu warten, während ein Speichersegment wieder aufgefrischt wird, bevor der Auslesevorgang erneut aufgenommen werden könnte. Da die dafür erforderliche Zeit einen merklichen Anteil der gesamten Auslesezeit ausmachen würde, ist es in hohem Masse erwünscht, diese Zeit vollständig aus der gesamten Auslesezeit herauszunehmen.

Somit wird gemäss der Erfindung zunächst festgestellt, ob das nächste in der Folge auszulesende Speichersegment während des nächstfolgenden Lese-Zeitintervalls eine Wiederauffrischung benötigt oder nicht. Ist dies der Fall, dann wird das Auswahlintervall für dieses Speichersegment in eine andere Auswahlfolge eingeordnet. Dies ist möglich, da die Daten aus der Speichereinheit in ganzen Datenblocks übertragen werden müssen und es dabei nicht wichtig ist, in welcher Reihenfolge die Daten innerhalb eines Blockes übertragen werden, wenn nur die Daten im richtigen Speicherplatz in richtiger Reihenfolge im Hauptspeicher 11 abgespeichert werden.

Um dies zu erreichen, enthält die Adresserzeugungsschaltung in der Steuerung 10 einen umlaufenden Binärzähler, dessen Anfangszählerstand dann auf das entsprechende Speichersegment eingestellt werden kann, wenn das Signal «VERSCHIEBE ANFANGS-ADRESSE» auftritt.

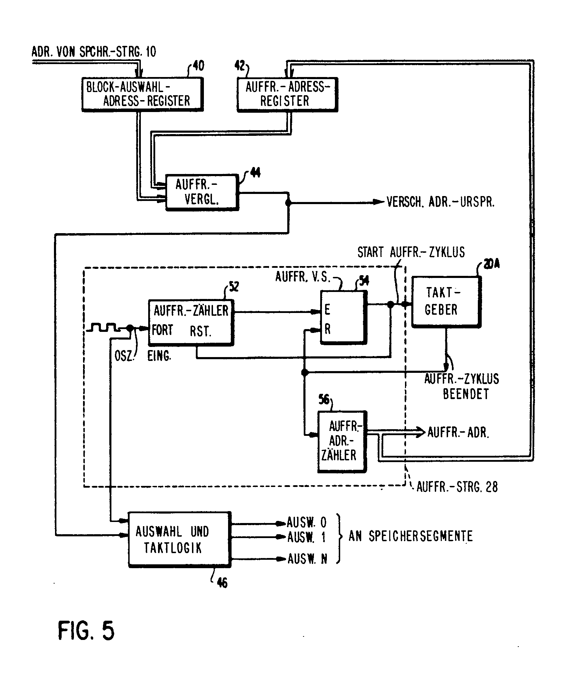

Die Schnittstellenlogik 20 stellt dabei fest, ob eine Wiederauffrischung während der nächstfolgenden Leseperiode erforderlich sein wird, wie dies noch im Zusammenhang mit Fig. 5 zu erläutern sein wird. Wird eine Anforderung zu einer Wiederauffrischung festgestellt, dann erzeugt die Schnittstellenlogik 20 das Signal «VERSCHIEBENE ANFANGS-ADRESSE», das der Steuerung 10 zugeführt wird. Die Steuerung 10 erzeugt anstelle der nächsten Adresse in der Folge, die dem wiederaufzufrischen Speichersegment entspricht, eine umgeordnete neue Adressfolge. Diese Umordnung hat zur Folge, dass mit einem Speichersegment begonnen wird, das an sich zu einem anderen Zeitintervall ausgewählt werden sollte, nämlich dem Speichersegment, das den Wiederauffrischungszyklus anforderte. Dadurch wird es möglich, dass das eine Wiederauffrischung anfordernde Speichersegment vor seinem Wiederauffrischungsintervall Daten überträgt und dann die Wiederauffrischung durchführt und abschliesst, während ein anderes Speichersegment für die Datenübertragung ausgewählt wird. Wenn andererseits das erste Speichersegment in einer Folge eine Wiederauffrischung durchzuführen hat, dann wird es zunächst übersprungen und überträgt seine Daten am Ende des für die Reihenfolge vorgesehenen Intervalls.

In Fig. 5 ist als Blockschaltbild ein Teil der Schnittstellenlogik 20 mit dem Taktgeber 20a und der Auffrischsteuerung 28 für die Speichereinheit 12 in Fig. 2 gezeigt. Die von der Steuerung 10 ankommende Adresse wird im Blockadressregister 40 eingespeichert. Die von der Auffrischsteuerung 28 erzeugte Adresse, die der Adresse des nächsten aufzufrischenden Speichersegments entspricht, ist im Auffrischadressregister 42 abgespeichert. Ein Vergleich zwischen den Ausgangssignalen der Register 40 und 42 wird durch den Auffrischvergleicher 44 durchgeführt. Sind die beiden digitalen Werte gleich, was dem Fall entspricht, dass die Adresse des nächsten aufzufrischenden Speichersegments die gleiche ist, wie die Adresse des Speichersegments, von dem normalerweise als nächstes Daten ausgelesen werden sollten, dann geht der Auffrischvergleicher 44 ausgangsseitig in seinen aktiven Zustand über und erzeugt das Signal «VERSCHIEBE ANFANGS-ADRESSE». Dieses Signal bewirkt, dass die Steuerung 10 die Ausgangsadresse dahingehend ändert, dass die Daten nunmehr vom nächsten Speichersegment in der Folge oder einem anderen Speichersegment ausgelesen werden, je nachdem welche Lösung bevorzugt wird. Danach nimmt das Signal «VERSCHIEBE ANFANGS-ADRESSE» wieder seinen inaktiven Zustand an.

Innerhalb der Auffrischsteuerung 28 liefert der Auffrischzähler 52 Ausgangsimpulse zu vorbestimmten Intervallen, die der Auffrischzeit der Speichersegmente 30 bis 34 entsprechen. Die vom Auffrischzähler 52 kommenden Ausgangsimpulse stellen zunächst die Auffrisch-Verriegelungsschaltung 54 in ihren aktiven Zustand ein, die daraufhin den Taktgeber 20a einschaltet. Das Ausgangssignal der Auffrisch-Verriegelungsschaltung 54 stellt ausserdem den Auffrischzähler 52 zurück.

Der Taktgeber 20a beginnt zu arbeiten, sobald er den am Ausgang der Auffrisch-Verriegelungsschaltung 54 erzeugten, den Beginn eines Auffrischzyklus anzeigenden Impuls aufgenommen hat und liefert nach Ablauf der der Auffrischzeit für jedes der Speichersegmente entsprechenden Zeitspanne ein den Abschluss eines Auffrischzyklus anzeigenden Impuls. Die Ausgangsimpulse des Taktgebers 20a schalten den Auffrischadresszähler 56 für jeden Zählwert um einen Impuls weiter. Das Ausgangssignal des Auffrischadresszählers 56 entspricht dann dem aufzufrischenden Speichersegment.

Die Auswahl- und Taktlogik 46 liefert Steuersignale auf den Auswahlleitungen 0 bis N, die an den einzelnen Speichersegmenten 30 bis 34 angeschlossen sind. Zu jedem beliebigen Zeitpunkt ist jeweils nur eine dieser Leitungen betätigt. Die Auswahl- und Taktlogik 46 enthält zu diesem Zweck ein umlaufendes Schieberegister, bei dem zu jedem beliebigen Zeitpunkt jeweils nur eine einzige Schieberegisterstufe an ihrem Ausgang im aktiven Zustand ist. Die Fortschaltung der Auswahl- und Taktlogik 46 wird durch den gleichen Oszillator gesteuert, der auch für den Auffrischzähler 52 zur Verfügung steht. Ist das Signal «VERSCHIEBE ANFANGS-ADRESSE» im akiven Zustand, dann wird die Auswahl- und Taktlogik 46 in ihren Ausgangszustand zurückgestellt, so dass die Leitung «AUSWAHL NULL» betätigt wird.

Als nächstes soll das Zeitdiagramm der Fign. 4A bis 4E betrachtet werden, um den zeitlichen Ablauf bei der Arbeitsweise der Erfindung besser darzustellen. Fig. 4A zeigt dabei die gesamte zum Auslesen erforderliche Zeit, wenn die Erfindung nicht benutzt wird. Zunächst wird ein Auffrischzeitintervall $t_0$ bis $t_1$ für das Auffrischen eines der Speichersegmente benötigt. Als zweites ist ein Datenübertragungsintervall von $t_1$ bis $t_2$ zum Auslesen eines einzigen Datenblockes erforderlich. Ohne das Auffrischintervall ist in Fig. 4B die zum Auslesen eines einzigen Datenblocks erforderliche Zeit $t_0$ bis $t_N$ gezeigt.

Ohne Einsatz der Erfindung muss, wie dies in Fig. 4C gezeigt ist, dann, wenn während der Blockübertragungszeit ein Auffrischintervall erforderlich ist, die Blockübertragungsoperation für das Auffrischintervall von $t'_0$ bis $t'_1$ angehalten werden, so dass sich die gesamte für das Auslesen eines Datenblocks erforderliche Zeit bis zum Zeitpunkt $t'_N$ verlängert.

Fig. 4D zeigt die Verteilung von Daten auf mehrere Speichersegmente, wobei $t_0$, $t_1$, .. $t_N$ die zum Auslesen erforderlichen Zeiten für die entsprechenden Speichersegmente ohne Auffrischung darstellen. Wenn eine Auffrischung während der $t_0$ entsprechenden Auswahlzeit erforderlich sein sollte, dann ist die entsprechende Folge beim Auslesen in Fig. 4E gezeigt. Die Operation «AUSLESEN VON DATENBLÖK-KEN» beginnt mit dem $t_1$ entsprechenden Speichersegment und durchläuft die Folge der Speichersegmente bis $t_N$ und geht dann zurück nach $t_0$. Die gleiche Folge kann durchlaufen werden für eine Auffrischung in $t_1$ bis $t_N$.

**Patentansprüche**

1. Speichersystem für Datenverarbeitungsanlagen, bestehend aus einem Hauptspeicher, einer Speichersteuerung (10) zum Einspeichern und Auslesen von Daten aus einer Anzahl daran angeschlossener Speichereinheiten (22, 24, 26) aus jeweils einer Anzahl Speichersegmente (30, 32, 34) für die Speicherung einer Anzahl von Datenbits, mit einer Auffrischsteuerung (28) für eine Auffrischung der in den einzelnen Speichersegmenten gespeicherten Daten innerhalb eines vorbestimmten Zeitintervalls, wobei die Auffrischsteuerung (28) mit einem Auffrisch-Adresszähler (56) für die taktgesteuerte Auffrischung des Speicherinhalts der Speichersegmente (30, 32, 34) innerhalb der vorgegebenen Zeitintervalle in einer vorgegebenen festen Reihenfolge versehen ist, welcher die aufeinanderfolgenden Auffrisch-Intervalle der Speichersegmente und damit das aufzufrischende Speichersegment (30, 32, 34) bestimmt, dadurch gekennzeichnet, dass ein an die Speichersteuerung (10) angeschlossenes Blockauswahl-Adressregister (40) zur Aufnahme der Blockadresse im nächsten auszulesenden Speichersegment, ein an den Auffrisch-Adresszähler (56) angeschlossenes Auffrisch-Adressregister (42) und ein an den Ausgängen dieser beiden Register angeschlossener Auffrischvergleicher (44) vorgesehen sind, an dessen Ausgang dann ein aktives Steuersignal (VERSCHIEBE ANFANGS-ADRESSE) auftritt, wenn die Adressen des nächsten auszulesenden Speichersegments und des nächsten aufzufrischenden Speichersegments übereinstimmen, dass eine durch die Auffrischsteuerung (28) steuerbare Auswahl- und Taktlogik (46) vorgesehen ist, mit deren Hilfe die in den Speichersegmenten eingespeicherten Daten ohne Verzögerung durch die periodische Auffrischung der Speichersegmente in der Weise auslesbar sind, dass die Adressen der Speichersegmente, aus denen Daten ausgelesen werden sollen, in einer von der vorgegebenen Reihenfolge abweichenden vorgegebenen zweiten Reihenfolge erzeugt werden, so dass dann, wenn ein erstes Speichersegment aufgefrischt werden soll, das als nächstes ausgelesen werden soll, der Auslesevorgang auf ein zweites Speichersegment umschaltbar ist, solange das erste Speichersegment aufgefrischt wird, worauf nach Beendigung des Auslesevorgangs des zweiten Speichersegments das zuvor übersprungene erste Speichersegment auslesbar ist.

2. Speichersystem nach Anspruch 1, dadurch gekennzeichnet, dass die Auffrischsteuerung (28) einen taktgesteuerten Auffrischzähler (52) und ein daran angeschlossenes bistabiles Zeitschaltglied (54) enthält, durch das der Auffrisch-Adresszähler (56) schrittweise fortschaltbar ist.

3. Speichersystem nach einem der Ansprüche 1 oder 2, dadurch gekennzeichnet, dass die Speichersegmente (30, 32, 34) aus Schieberegistern mit ladungsgekoppelten Schaltungen bestehen.

4. Speichersystem nach einem der Ansprüche 1 oder 2 oder 3, dadurch gekennzeichnet, dass die Speichersegmente jeweils aus dynamischen, zeilenadressierbaren Speichern mit wahlfreiem Zugriff bestehen.

**Claims**

1. A storage system for data processing equipment, comprising a main storage, a storage control (10) for storing data in and reading them from a plurality of storage units (22, 24, 26) connected thereto and comprising a plurality of storage segments (30, 32, 34) for the storage of a plurality of data bits, with a refresh control (28) for refreshing the data stored in the individual storage segments within a predetermined time interval, wherein the refresh control (28) is provided with a refresh address counter (56) for the clock-controlled refreshing of the stored contents of the storage segments (30, 32, 34) within the predetermined time intervals in a predetermined fixed order, said refresh address counter determining the successive refresh intervals of the storage segments and thus the storage segment (30, 32, 34) to be refreshed, characterized in that there are provided a block selection address register (40) connected to the storage control (10) and accommodating the block address in the storage segment to be read next, a refresh address register (42) connected to the refresh address counter (56), and a refresh comparator (44), connected to the outputs of these two register, at whose output an active control signal (SHIFT START ADDRESS) is emitted if the addresses of the storage segment to be read next and the storage segment to be refreshed next match, that a selection and clock logic (42) controllable by the refresh control (28) is provided, by means of which the data stored in the storage segments can be read without delay by periodically refreshing the storage segments in such a manner that the addresses of the storage segments, from which data are to be read, are generated in a second order differing from the predetermined order, so that if a first storage segment is to be refreshed which is to be read next, the read process is switched to a second storage segment, while the first storage segment is being refreshed, the first storage segment previously skipped being read after the reading of the second storage segment has been completed.

2. The storage system according to claim 1, characterized in that the refresh control (28) has a clock-controlled refresh counter (52) and a bistable time switch element (54) connected thereto, by means of which the refresh address counter (56) is incremented in steps.

3. The storage system according to claim 1 or claim 2, characterized in that the storage segments (30, 32, 34) consist of shift registers with charge-coupled circuits.

4. The storage system according to any one of the claims 1 or 2 or 3, characterized in that the storage segments each consist of dynamic, line-addressable, random-access storage.

**Revendications**

1. Système de mémoire pour des systèmes de traitement de données comportant une mémoire principale, une commande de mémoire (10) pour emmagasiner et lire des données de plusieurs unités de mémoire (22, 24, 26) connectées à cette commande, les unités de mémoire étant composées d'un certain nombre des segments de mémoire (30, 32, 34) pour emmagasiner plusieurs bits de données, une commande de régéneration (28) pour régénérer les données emmagasinées dans les différents segments de mémoire pendant un intervalle de temps prédéterminé, la commande de régénération (28) comprenant un compteur d'adresses de régénération (56) pour la régénération cadencée du contenu de mémoire des segments de mémoire (30, 32, 34) pendant les intervalles de temps prédéterminés dans un ordre fixe prédéterminé, ledit compteur d'adresses de régénération déterminant les intervalles de régénération successifs des segments de mémoire et par conséquent le segment de mémoire à régénérer (30, 32, 34), caractérisé en ce qu'il est prévu un registre d'adresses de sélection de bloc (40) connecté à la commande de mémoire (10) pour recevoir l'adresse de bloc dans le segment de mémoire suivant à lire, un registre d'adresses de régénération (42) connecté au compteur d'adresses de régénération (56) et un comparateur de régénération (44) connecté aux sorties de ces deux registres, un signal de commande actif (adresse initiale de décalage) étant appliqué à la sortie dudit comparateur lorsque les adresses du segment de mémoire suivant à lire et du segment de mémoire suivant à régénérer concordent, en ce qu'il est prévu une logique de cadence et de sélection (46) commandée par la commande de régénération (28), qui, par une régénération périodique des segments de mémoire permet de lire les données emmagasinées dans les segments de mémoire sans retard de telle sorte que les adresses des segments de mémoire, à partir desquels des données doivent être lues, sont générées dans un second ordre prédéterminé différent de l'ordre prédéterminé, de sorte que, lorsqu'un premier segment de mémoire qui est le suivant à lire doit être régénéré, le processus de lecture est commuté à un second segment de mémoire pendant que le premier segment de mémoire est régénéré, le premier segment de mémoire, ayant été précédemment sauté, étant lu après la fin du processus de lecture du second segment de mémoire.

2. Système de mémoire selon la revendication 1, caractérisé en ce que la commande de régénération (28) comporte un compteur de régénération (52) cadencé et un élément de temps bistable (54) connecté à celui-ci, ledit élément de temps incrémentant le compteur d'adresses de régénération (56) pas-à-pas.

3. Système de mémoire selon l'une des revendications 1 ou 2, caractérisé en ce que les segments de mémoire (30, 32, 34) sont constitués par des registres à décalage comportant des circuits à transfert de charge.

4. Système de mémoire selon l'une quelconque des revendications 1 ou 2 ou 3, caractérisé en ce que les segments de mémoire sont constitués par des mémoires dynamiques à accès aléatoire et à lignes adressables.

## FIG. 1

HAUPT-
SPEICHER

DATEN

ADRESSE

SPEICHER-
STEUERUNG

ADRESSE

STEUERUNG & TAKTGABE

SPEICHER
1

SPEICHER
2

SPEICHER
N

DATEN

## FIG. 3

VON SCHNITTSTELLEN-
LOGIK UND
TAKTGABE

SPEICHEREINHEIT 22

AUSWAHL N

AUSWAHL 2

AUSWAHL 1

SPEICHER-
SEGMENT N

SPEICHERSEGMENT 2

SPEICHER-
SEGMENT 1

TAKTGABE

DATEN

FIG. 2

0 013 697

11

# FIG. 4A – SPEICHERSEGMENT

# FIG. 4B – SYSTEM- ODER BLOCK-ÜBERTR.-INTERVALL OHNE AUFFR.

# FIG. 4C – BLOCK-ÜBERTR. MIT AUFFR.

# FIG. 4D – VERT. DATENSEGMENTE

# FIG. 4E – VERSCH. AUSWAHL NACH NEUEM URSPRUNG, VERMEIDET AUFFRISCHUNG

FIG. 5